# EUROPEAN PATENT APPLICATION

(11) **EP 4 464 479 A1**
(43) Date of publication of application: **20.11.2024**
(21) Application number: 23173449.2
(22) Date of filing: 15.05.2023
(51) Int. Cl.: B26D 1/00, B26B 21/58, B26B 21/60, B32B 15/00, B32B 18/00

(54) **COMPOSITE OF A SUBSTRATE COATED WITH A MECHANICALLY INTERLOCKED COATING, CUTTING ELEMENT AND METHOD FOR DEPOSITING A MECHANICALLY INTERLOCKED COATING UPON A SUBSTRATE**

(71) Applicant: GFD Gesellschaft für Diamantprodukte mbH, 89231 Ulm (DE)
(72) Inventor: Gluche, Peter, 89287 Bellenberg (DE); Mertens, Michael, 89269 Vöhringen/Illerberg (DE); Gretzschel, Ralph, 89231 Neu-Ulm/Offenhausen (DE)
(74) Representative: Pfenning, Meinig & Partner mbB

(57) **Abstract**

The present invention relates to a composite of a substrate coated with a mechanically interlocked coating having a substrate with a surface in contact with a coating. The substrate has at least in regions of the surface a plurality of recesses at the surface and the coating extends into the recesses of the substrate forming a mechanical interlocking structure between the substrate and the coating. Moreover, the present invention relates to a cutting element formed from the composite and a method for depositing a mechanically interlocked coating upon a substrate.

## Description

The present invention relates to a composite of a substrate coated with a mechanically interlocked coating having a substrate with a surface in contact with a coating. The substrate has at least in regions of the surface a plurality of recesses at the surface and the coating extends into the recesses of the substrate forming a mechanical interlocking structure between the substrate and the coating. Moreover, the present invention relates to a cutting element formed from the composite and a method for depositing a mechanically interlocked coating upon a substrate.

For many engineering applications, substrate materials are coated with a soft or hard material coating layer to enhance the performance of the substrate material. For instance, hard coatings are applied to increase wear resistance of the substrate material or soft coatings are applied to improve friction properties of the substrate material. Thus, the substrate material plus the coating from a layered composite material with enhanced functional properties.

Coatings may be applied by methods such as spraying, dipping, rolling or through physical vapor deposition PVD, chemical vapor deposition CVD, atomic layer deposition ALD or galvanic deposition. To achieve the desired function of enhancing the substrate materials' performance, it is important that the coating adheres sufficiently to the substrate and does not separate, peel off, flake off, delaminate, or crack after being deposited onto the substrate or during the usage of the layered composite.

When such a layered composite is exposed to e.g., bending, or shearing action, stresses may arise along the interface between the substrate and coating layer and lead to the separation of the two materials. Stresses along the interface can also arise from different thermal expansion coefficients, or thermally induced stress. Typically, the substrate material and the coating material have a different thermal expansion coefficient. If the coating layer is e.g. deposited onto the substrate surface at an elevated temperature, thermal stress will arise at the interface once the layered composite has cooled to ambient temperature. Thermal stress may also be induced by composites that are relaxed at room temperature but operated at elevated or reduced temperatures.

Therefore, it is important that the substrate material and the coating are securely bonded to each other at the interface, through either chemical, e.g. covalent atomic bonding, or physical bonding, e.g. van der Waals bonding, and/or through mechanical interlocking between the substrate material and the coating layer.

Physical bonding, e.g. van der Waals interaction at the interface is always present between the substrate material and the coating layer, however, this interaction force is rather weak, and the coating may separate from the substrate when stresses arise at the interface.

Chemical bonding, e.g. the formation of atomic or covalent bonds may be stronger, but they only form if the substrate and the coating material undergo a chemical reaction to form such bonds. In some cases, the chemical reaction requires the input of additional energy, e.g. heat or it requires one of both materials to be ionized before coming in contact. For some material combinations the formation of covalent bonds may not be possible or the strength of the covalent bonds is not sufficient between the substrate and coating material at the interface. For example, hard coatings like diamond like carbon (DLC) may be applied to substrate materials like plastic or metal at elevated temperatures, but do not form covalent bonds and the DLC coating adheres only through van der Waals interaction on the substrate.

A solution known in the prior art to increase the adhesion strength between a substrate material and a coating layer is the introduction of a separate, additional layer, known as the adhesion promoting layer, at the interface between the substrate and the coating. Such an adhesion promoting layer is typically only 10 to a few 100 nm thick and has a chemical composition that forms strong bonds with both the adjacent materials, the substrate and the coating. However, the introduction of an adhesion promoting layer introduces additional material and increases the complexity of the interface. Thus, it may not be desirable for the application.

Mechanical interlocking between the substrate material and the coating layer can be achieved by depositing the coating layer onto a substrate material that has a naturally or intentionally created rough surface. The typical surface finishing roughness is less than 10 µm. Alternatively, the surface of the substrate material can be structured by creating physical recesses or protrusions on a lateral length scale of µm which is an important option for substrate surfaces that are smooth or chemically less reactive like, e.g. glass.

US 2017/0121232 discloses a mechanical interlocking structure comprising of lateral grooves formed in the substrate surface by laser ablation, however, the grooves are 10 to 50 µm deep, which yields to the destruction the substrate surface, so that the original surface plane can no longer be determined and the substrate thickness is no longer defined. Furthermore, creating a surface texture by laser ablation results in the formation of castoffs caused by molten substrate material re-solidifying at the edges of the features, which is an uncontrolled process. Furthermore, the high laser energy may change the composition and morphology of the substrate material at the interface.

It is therefore desirable to create a controlled mechanical interlocking structure between a substrate material and a coating layer that causes minimal damage to the materials involved.

In some applications the coating layer may not cover the entire substrate surface and areas of the substrate surfaces remain uncoated. In this case, it may be desirable to avoid any structuring in such regions of the substrate. Alternatively, additional processing of the layered composite material may selectively remove areas of the substrate material and leave areas of the coating layer exposed. In this case, it may be desirable for the exposed surface area of the coating layer not to contain any structuring.

There is a continuing need to optimize the adhesion between the coating layer and the substrate materials with precise control of the adhesion properties and the surface roughness. The adhesion properties should be tailored towards the application and induce minimal damage to the substrate surface.

The present invention therefore addresses the mentioned drawbacks in the prior art and provides a composite of a substrate coated with a mechanically interlocked coating, as well as a method for depositing a mechanically interlocked coating upon a substrate.

This problem is solved by the composite of a substrate coated with a mechanically interlocked coating with the features of claim 1, the cutting element with the features of claim 16 and the method for realizing a mechanically interlocked coating upon a substrate with the features of claim 17. The further dependent claims define preferred embodiments.

The following definitions are used in the present application:

### Recess:

A recess is formed by the removal or absence of material from the surface and extending below the surface of a solid substrate (host material) so that the recess is devoid of the substrate (host material) and open to the surroundings and accessible from the surface, i.e. it could be filled with another gaseous, liquid or solid substance or left empty. A recess has an opening with a perimeter in the surface of the host material, a base within the host material and a side wall within the host material that connects the perimeter of the opening to the base.

### Protrusion:

A protrusion is formed by the addition or presence of material on a surface and extends beyond the surface of a solid substrate (host material).

### Largest inner circle:

The largest inner circle is a circle that can be fully fitted into any 2-dimensional planar shape that has a closed outer perimeter including circles, oval shapes or polygons. The largest inner circle will coincide with the perimeter of the closed 2-dimensional planar shape in each least 3 points and it will not extend beyond the perimeter at any point.

### Depth (of recess):

The depth d_{base} of a recess is the vertical distance from the surface of the substrate (host material) to the lowest point on the base of the recess within the substrate. The depth dₚₐᵢᵣ of a pair of recesses is the average depth of two recesses that are adjacent to each other.

### Width (of recess):

The width w_{surf} of a recess is the diameter of the largest inner circle that can be fully fitted into the perimeter of the opening of the recess in the surface plane of the substrate (host material). The width wₚₐᵢᵣ of a pair of recesses is the average width of two recesses that are adjacent to each other.

### Undercut:

An undercut refers to the shape of the side wall of a recess which has at least one width below the substrate surface that is larger than the width w_{surf} of the opening of the recess. The maximum width wₘₐₓ is the diameter of the largest inner circle that can be fully fitted into the largest perimeter of the recess in a plane parallel to the surface of the substrate at a depth dₘₐₓ which is a depth below the surface of the substrate and above or at the depth d_{base} of the base of the recess.

### Spacing (of recesses):

The spacing s is the distance between any two adjacent recesses measured between the centres of the two adjacent recesses, whereby the centre of a recess is defined as the centre of the largest inner circle that fully fits into the perimeter of the recess opening.

### Region:

The surface of the substrate may be subdivided into a plurality of smaller areas that are referred to as regions.

The term "comprising" in the claims and in the description of this application has the meaning that further components are not excluded. Within the scope of the present invention, the term "consisting of" should be understood as preferred embodiment of the term "comprising". If it is defined that a group "comprises" at least a specific number of components, this should also be understood such that a group is disclosed which "consists" preferably of these components.

According to the present invention a composite of a substrate coated with a mechanically interlocked coating is provided, wherein the composite comprises or consists of a substrate with a surface in contact with a coating.The substrate has at least in regions of the surface a plurality of recesses at the surface and the coating extends into the recesses of the substrate forming a mechanical interlocking structure between substrate and coating.

Creating such a structured surface of the substrate has the advantage, that the adhesion can be tailored. The adhesion strength can be optimised by selecting the width, depth, spacing and shape of the recesses or protrusions. The distribution may be regular or random, while the shape of the recesses or protrusions may contain undercuts for better interlocking of the two materials.

It is preferred that the recesses have a width w_{surf}, which is preferably in a range of 100 nm to 100 µm, more preferably from 500 nm to 20 µm, and a depth d_{base}, which is preferably in a range 50 nm to 5 µm, more preferably from 100 nm to 2 µm, with the proviso that the ratio w_{surf}/d_{base} is in the range from 0.20 to 25, preferably in the range from 1 to 20, and more preferably in the range from 5 to 15.

According to a preferred embodiment, the recesses are arranged such that the ratio wₚₐᵢᵣ/s of the average width wₚₐᵢᵣ of a pair of two adjacent recesses to the spacing s of the same pair of two adjacent recesses is preferably in the range from 0.1 to 0.95, preferably 0.3 to 0.9, more preferably 0.4 to 0.8, and even more preferably 0.5 to 0.75.

In a preferred embodiment of the invention the recesses are arranged such that the ratio s/dₚₐᵢᵣ of the spacing s of any pair of two adjacent recesses to the average depth dₚₐᵢᵣ of the same pair of tow recesses is preferably in the range from 0.25 to 20, more preferably in the range from 0.5 to 15, and even more preferably in the range from 1 to 12.

It is preferred that the substrate comprises or consists of a material selected from the group
- metals, preferably titanium, nickel, chromium, niobium, tungsten, tantalum, molybdenum, vanadium, platinum, germanium, iron, and alloys thereof, in particular steel,
- ceramics comprising at least one element selected from the group consisting of carbon, nitrogen, boron, oxygen or combinations thereof, preferably silicon carbide, zirconium oxide, aluminum oxide, silicon nitride, boron nitride, tantalum nitride, TiAIN, TiCN, and/or TiB₂,
- glass ceramics; preferably aluminum-containing glass-ceramics,
- composite materials made from ceramic materials in a metallic matrix (cermets),
- hard metals, preferably sintered carbide hard metals, such as tungsten carbide or titanium carbide bonded with cobalt or nickel,
- single crystalline silicon or germanium, preferably with the crystalline plane parallel to the surface, wafer orientation <100>, <110>, <111> or <211>,
- glass or sapphire,
- polycrystalline or amorphous silicon or germanium,
- mono- or polycrystalline diamond, diamond like carbon (DLC), adamantine carbon and
- combinations thereof,

More preferably, the substrate comprises or consists of silicon, steel and combinations thereof.

The steels used for the first material are preferably selected from the group consisting of 1095, 12C27, 14C28N, 154CM, 3Cr13MoV, 4034, 40X10C2M, 4116, 420, 440A, 440B, 440C, 5160, 5Cr15MoV, 8Cr13MoV, 95X18, 9Cr18MoV, Acuto+, ATS-34, AUS-4, AUS-6 (= 6A), AUS-8 (= 8A), C75, CPM-10V, CPM-3V, CPM-D2, CPM-M4, CPM-S-30V, CPM-S-35VN, CPM-S-60V, CPM-154, Cronidur-30, CTS 204P, CTS 20CP, CTS 40CP, CTS B52, CTS B75P, CTS BD-1, CTS BD-30P, CTS XHP, D2, Elmax, GIN-1, H1, N690, N695, Niolox (1.4153), Nitro-B, S70, SGPS, SK-5, Sleipner, T6MoV, VG-10, VG-2, X-15T.N., X50CrMoV15, ZDP-189.

A martensitic stainless steel substrate is preferred for the production of cutting elements such as cutlery, surgical knives, and razor blades because it has high hardness and good corrosion resistance. Particularly, a high-carbon martensitic stainless steel strip material containing Cr in an amount of about 13% by mass is preferred as a substrate material for razor blades.

The substrate material preferably has a thermal expansion coefficient of 0.9 to 20 ppm/K (at 20°C), more preferably of 1 to 15 ppm/K and even more preferably from 2 to 5 ppm/K.

The substrate has preferably a Young's modulus of 50 to 1000 GPa, more preferably of 75 to 800 GPa and even more preferably from 100 to 400 GPa.

It is preferred that the coating comprises or consists of a material selected from the group consisting of hard materials (hard coatings) like
- oxides, nitrides, carbides, borides, preferably aluminum nitride, chromium nitride, titanium nitride, titanium carbon nitride, titanium aluminum nitride, cubic boron nitride
- boron aluminum magnesium
- carbon, preferably diamond, nano-crystalline diamond, micro-crystalline diamond, polycrystalline diamond, mono-crystalline diamond, diamond like carbon (DLC) like tetrahedral amorphous carbon,

Moreover, all materials cited in the VDI guideline 2840 can be chosen for the hard coating material.

Alternatively, it is preferred that the coating comprises or consists of a material selected from the group consisting of soft materials (soft coatings) like low-friction materials, preferably selected from the group consisting of polymers, in particular fluoropolymers (preferably polytetrafluoroethylene (PTFE)), silicon-based polymers (preferably silicones, parylene, polysilazanes, polyvinylpyrrolidone, polyethylene, polypropylene, polymethyl methacrylate, graphite, and combinations thereof.

It is particularly preferred to use a hard coating material of nano-crystalline diamond and/or multilayers of nano-crystalline and coarse-grained polycrystalline diamond as coating material. Relative to monocrystalline diamond, it has been shown that the production of nano-crystalline diamond, compared to the production of monocrystalline diamond, can be accomplished substantially more easily and economically. Moreover, with respect to their grain size distribution, nano-crystalline diamond layers show a more homogeneous morphology than coarse grained polycrystalline diamond layers, the material also shows less inherent stress. Consequently, macroscopic deformation of a cutting element produced from nano-crystalline diamond is less probable.

It is also preferred that the substrate is coated with more than one coating, e.g. a first hard coating on the substrate and a second soft coating deposited on the hard coating.

It is preferred that the hard coating has a modulus of elasticity (Young's modulus) of less than 1200 GPa, preferably less than 900 GPa, more preferably less than 750 GPa and even more preferably from 50 GPa to 500 GPa. Due to the low modulus of elasticity the hard coating becomes more flexible and more elastic. The Young's modulus for diamond materials is determined according to the method as disclosed in Markus Mohr et al., "Youngs modulus, fracture strength, and Poisson's ratio of nanocrystalline diamond films", J. Appl. Phys. 116, 124308 (2014), in particular under paragraph III. B. Static measurement of Young's modulus.

The hard coating has a transverse rupture stress σ₀ of 1 GPa to 15 GPa, preferably of 2.5 GPa to 10 GPa, more preferably of 5 GPa to 8 GPa.

With respect to the definition of transverse rupture stress σ₀, reference is made to the following literature references:
- R.Morrell et al., Int. Journal of Refractory Metals & Hard Materials, 28 (2010), p. 508 -515
- R. Danzer et al. in "Technische keramische Werkstoffe", published by J. Kriegesmann, HvB Press, Ellerau, ISBN 978-3-938595-00-8, chapter 6.2.3.1 "Der 4-Kugelversuch zur Ermittlung der biaxialen Biegefestigkeit spröder Werkstoffe"

The transverse rupture stress σ₀ is thereby determined by statistical evaluation of breakage tests, e.g., in the B3B load test according to the above literature details. It is thereby defined as the breaking stress at which there is a probability of breakage of 63%.

Due to the extremely high transverse rupture stress of the hard coating material the detachment of individual crystallites from the hard coating is almost completely suppressed.

The hard coating has preferably a hardness of 20 GPa to 100 GPa, more preferably of 25 GPa to 50 GPa. The hardness is determined by nanoindentation (Yeon-Gil Jung et. al., J. Mater. Res., Vol. 19, No. 10, p. 3076).

For a nano-crystalline diamond hard coating the average grain size d₅₀ of the nano-crystalline diamond of preferably 1 to 100 nm, more preferably from 5 to 90 nm, even more preferably from 7 to 30 nm, and most preferably from 10 to 20 nm. The average grain size d₅₀ is the diameter at which 50% of the second material is comprised of smaller particles. The average grain size d₅₀ may be determined using X-ray diffraction or transmission electron microscopy and counting of the grains. For coarse grained polycrystalline diamond the average grain size d₅₀ of the diamond film is preferably in the range from more than 100 nm to 1500 µm.

The hard coating has preferably a thermal expansion coefficient of 0.9 to 8 ppm/K (at 20°C), more preferably of 0.95 to 5ppm/K and even more preferably from 1 to 3 ppm/K.

The opening perimeter of the recesses may be of arbitrary shape, but the preferred shape of the recess opening has no corners, i.e., the recess opening perimeter is a closed continuous line without any singularities, preferably the recesses have a circular or ellipsoidal shape, but may also be of linear shape.

The recess preferably comprises a sidewall in the shape of an undercut, which means that the recess has at least one width below the substrate surface that is greater than the width of the opening of the recess w_{surf}. This improves the mechanical interlocking of the coating layer with the substrate material because some of the coating material will fill the undercut in the substrate material and thus be located beneath the surface of the substrate. This increases the adhesion between the substrate and the coating because separation of the coating layer from the substrate material would require breaking out some of the substrate material near the surface away.

It is preferred that the coating has a thickness T_{c} of 100 nm to 50 µm, preferably 150 nm to 20 µm, more preferably 200 nm to 15µm.

The substrate has a preferably a thickness Tₛ of 20 to 2000 µm, more preferably 30 to 1000 µm, and even more preferably 50 to 400 µm.

According to a preferred embodiment, the composite has a total thickness Tₜₒₜ of 25 to 2050 µm, preferably 50 to 1000 µm, and more preferably 100 to 400 µm.

It is preferred that the ratio d_{base}/T_{c} of the depth d_{base} of the recesses to the thickness of the coating T_{c} is in a range of 0.01 to 15, preferably 0.1 to 5, more preferably 0.5 to 2.

According to a further aspect of the present invention, a cutting element with a cutting edge is provided, which is formed from the composite as described above. The cutting element is preferably a knife blade, razor blade, scalpel, knife, machine knife in slitting, burst and crash cutting systems, scissors or shear cutting systems.

Cutting edges may be produced by partially removing the substrate material until only the coating material (which is preferably a hard coating) remains and subsequently forming a cutting edge in the free-standing coating layer. If the substrate material contains recesses in its surface, the coating layer contains protrusions that were formed during the coating process when the coating materials filled the recesses in the substrate material. These protrusions mirror the shape and distribution of the recesses that were created in the surface of the substrate material prior to depositing the coating layer. However, in the case of cutting edges formed in the free-standing coating layer by partially removing the substrate material, it is desirable not to have protrusions on the cutting edge regions. Protrusion on the cutting edge may cause the cutting edge to be ragged and the beveled surface to be rough which may lead to poor cutting performance and instability of the cutting element. It is therefore desirable to avoid protrusions the cutting edge regions, which requires that recesses must not be present on the surface of the substrate in regions where the substrate will be removed after the coating process to form cutting edges.

According to a further aspect of the present invention a method for depositing a mechanically interlocked coating upon a substrate is provided which comprises the following steps:
a) Providing a substrate with a surface,
b) forming an etching mask with openings at the surface of the substrate,
c) etching the substrate through the openings in the etching mask to form a plurality of recesses at the surface of the substrate by reactive ion etching or wet chemical etching,
d) depositing a coating onto the substrate surface and into the plurality of recesses.

In a preferred embodiment, after step c) the etching mask is removed from the substrate.

The present invention is further illustrated by the following figures and examples which show specific embodiments according to the present invention. However, these specific embodiments shall not be interpreted in any limiting way with respect to the present invention as described in the claims in the general part of the specification.
- Fig. 1a to c: show a top view, cross section and enlarged cross section of a recess.
- Fig. 2: shows a cross section of a composite of the present invention.
- Fig. 3: is a top view of a substrate onto the surface.
- Fig. 4: is a cross-section of a substrate of the present invention.
- Fig. 5a to c: are scanning electron microscopic (SEM) images of the substrate and the composite according to the present invention.
- Fig. 6: shows alternative recess shapes according to the present invention.
- Fig. 7: is a schematic illustration of the process steps of the method according to the present invention.
- Fig. 8a to d: are schematic illustrations of the deposition of the coating layer onto a substrate material according to the present invention.
- Fig. 9: shows schematic top views and cross sections of a cutting element at different stages during the process according to the present invention.
- Fig. 10a, b, c: showing schematic cross sections of the cutting element formation process.
- Fig. 11: is a light microscopy photograph of a top view of a cutting edge.

### Reference sign list

- 10: composite
- 110: interface
- 20: substrate (material)
- 200: substrate surface
- 205: substrate backside surface
- 210: photoresist
- 220: exposed photoresist regions
- 230: unprotected regions
- 240: region with recesses
- 250: region without recesses
- 30: coating (layer)
- 300: coating surface
- 305: coating inner surface
- 320: protrusion
- 330: coating recess
- 40, 40', 40", 40‴: recesses
- 410: recess opening
- 415: side wall
- 420: recess base
- 460: recess opening perimeter
- 462: recess maximum perimeter
- 470: largest inner circle
- 472: recess centre
- 480: undercut
- 600: cutting element
- 610: cutting edge
- 620: cutting bevel
- 630: cutting element body

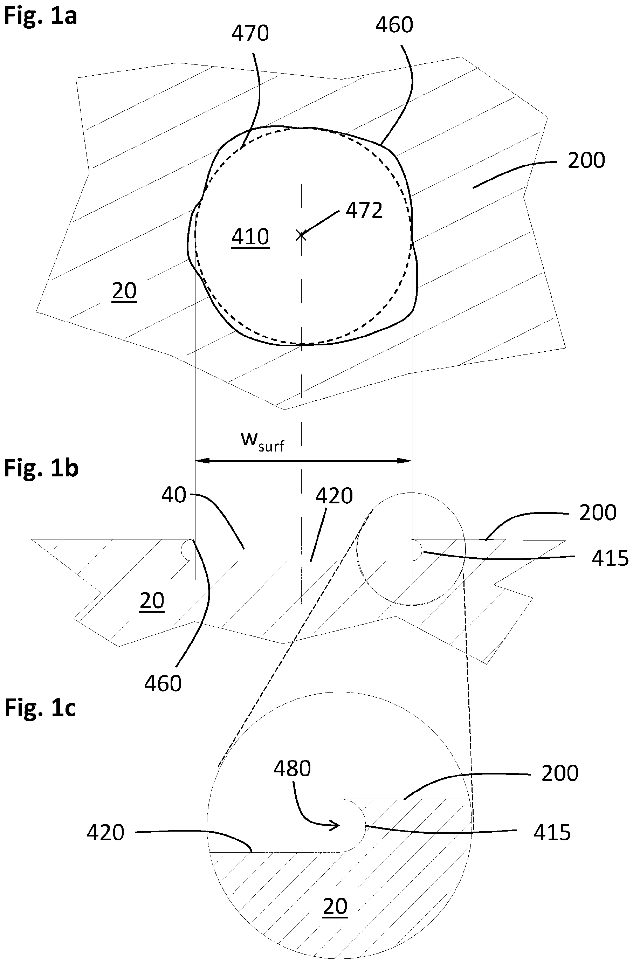

Fig. 1a shows the top view of a recess 40 in a substrate 20. The recess 40 has an opening 410 with an opening perimeter460, both of which lie in the surface 200 of substrate 20. The opening perimeter 460 may be of arbitrary shape, but the preferred shape of the recess opening 410 has no corners, i.e., the recess opening perimeter 460 is a closed continuous line without any singularities. The width w_{surf} of the recess is the diameter of the largest inner circle 470 that can be fitted fully within the perimeter 460 of the opening 410 as shown by the dotted line in Fig. 1a. The circumference of this largest inner circle 470 may coincide with the perimeter 460 of the recess opening 410 but may not exceed beyond the perimeter 460 of the recess opening 410. The centre of the largest inner circle 470 defines the recess centre 472 of the recess.

Fig. 1b shows the cross section of the recess 40 in a substrate 20 from Fig. 1a. The recess 40 comprises an opening 410 located in the surface 200 of the substrate 20, and a base 420 and a side wall 415 located within the substrate 20. The opening 410 has a width w_{surf} as defined by the largest inner circle 470. As can be seen form the enlargement of the side wall 415 on Fig. 1c, the side wall 415 has an undercut 480. This results in the recess 40 having a width at a depth below the substrate surface 200 that is greater than the width w_{surf} of the opening 410 of the recess 40 at the substrate surface 200. The width of the recess 40 at any depth below the substrate surface 200 is defined by the diameter of the largest inner circle that can be entirely placed within the perimeter of the recess at this depth below the substrate surface 200 whereby the perimeter lies within a plane parallel to the substrate surface at this depth.

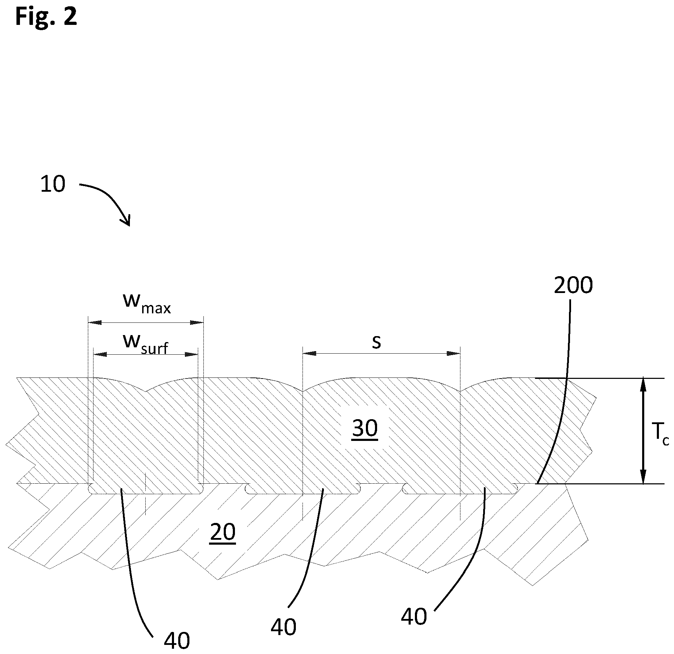

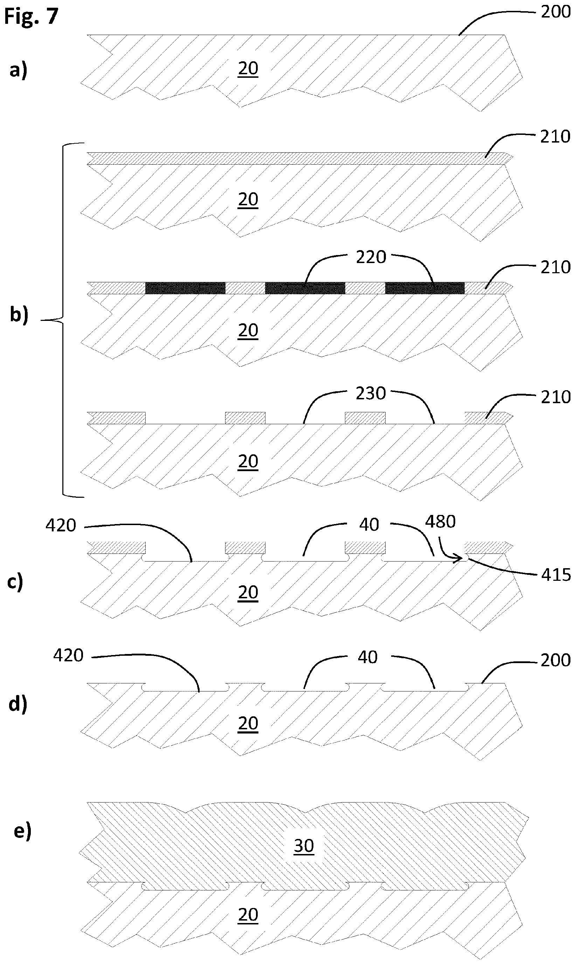

Fig. 2 shows a cross-sectional view of a composite 10 comprising a substrate material 20 and a coating layer 30. The substrate material 20 is made of silicon. The substrate material 20 has a surface 200. The substrate material 20 comprises a plurality of recesses 40, which have been etched into the surface 200 according to the method described below and illustrated in Fig. 7. Each recess 40 has an opening at the surface 200 with a width w_{surf}. Furthermore, each recess 40 has a maximum width wₘₐₓ at a depth dₘₐₓ below the surface 200. Adjacent recesses 40 are separated by a spacing s. The coating layer 30 consists of nano-crystalline diamond. The coating layer 30 is deposited onto the structured surface 200 of the substrate material 20 according to the method described below and illustrated in Fig. 7. The coating layer 30 has a coating thickness T_{c}.

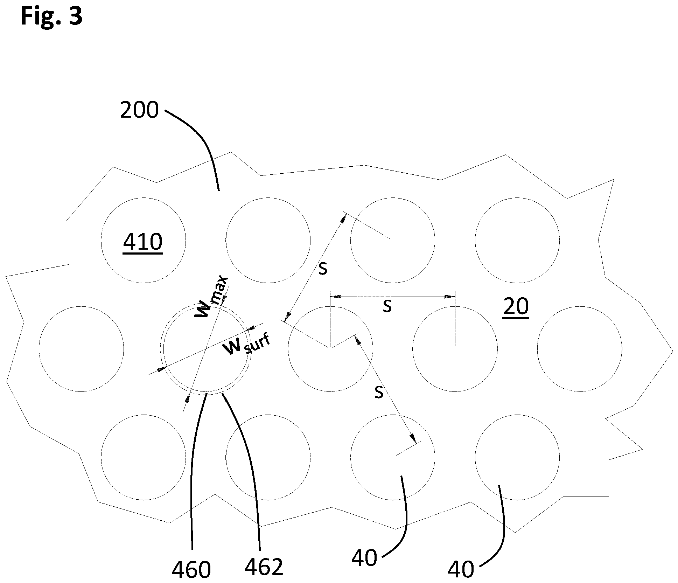

Fig. 3 shows a top view of the surface 200 of a substrate material 20. The substrate material 20 comprises a plurality of recesses 40, which have been etched into the surface 200 according to the method described below and illustrated in Fig. 7. Each recess 40 has an opening 410 at the surface 200 with a width w_{surf} and a recess opening perimeter 460 around the opening 410 of recesses 40. Furthermore, each recess 40 has a maximum width wₘₐₓ at a maximum depth dₘₐₓ below the surface 200. Adjacent recesses 40 are separated by a spacing s.

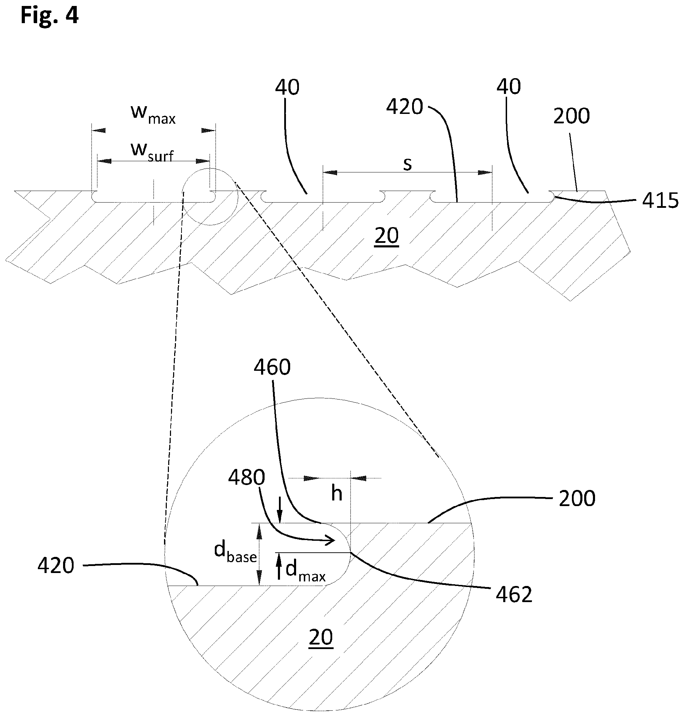

Fig. 4 shows a cross sectional view of a substrate material 20. The substrate material 20 comprises a plurality of recesses 40, which have been etched into the surface 200 according to the method described below and illustrated in Fig. 7. Each recess 40 has an opening at the surface 200, a sidewall 415 and a base 420 at a depth d_{base} below the surface 200.

As can be seen form the magnification of a sidewall 415 of a recess 40, an opening perimeter 460 is located around the opening of recesses 40. Furthermore, each recess 40 has a maximum perimeter 462 at a maximum depth dₘₐₓ below the surface 200. The largest inner circle that can be fully fitted into the opening perimeter 460 defines the surface width w_{surf} and the largest inner circle that can be fully fitted into the maximum perimeter462 defines the maximum width wₘₐₓ. The difference of wₘₐₓ minus w_{surf} corresponds to the twice the width of the overhang h. The depth dₘₐₓ is greater than zero but less or equal than the depth d_{base} of the recess 40, meaning that the maximum perimeter 462 and hence maximum width wₘₐₓ is located below the surface 200 of the substrate 20 to form and undercut 480. Adjacent recesses 40 are separated by a spacing s.

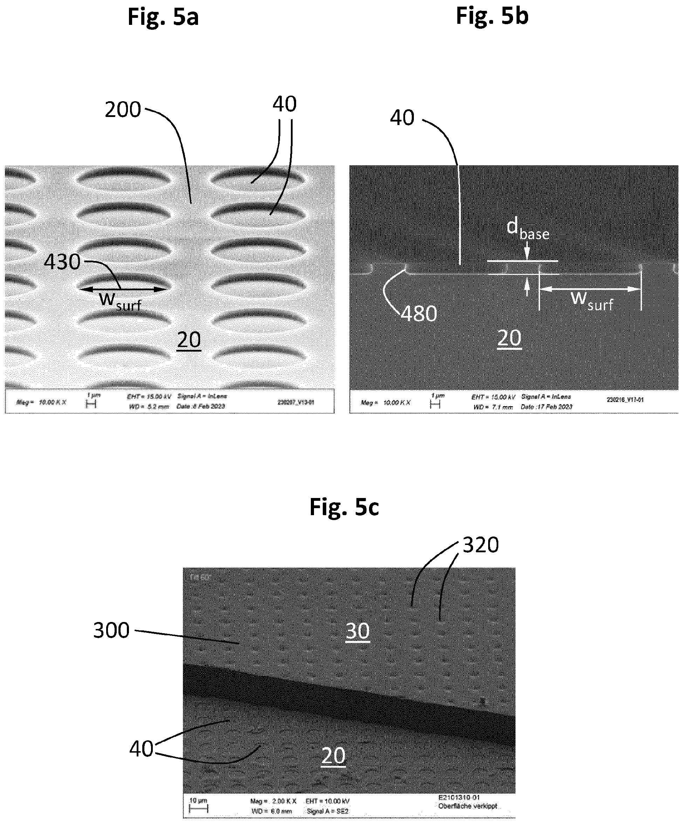

Fig. 5a shows a perspective scanning electron micrograph (SEM) of a surface 200 of a substrate material 20 comprising a plurality of circular recesses 40. As can be inferred from the scale bar, the opening width w_{surf} of recesses 40 is approx. 10 µm in this example.

Fig. 5b shows a cross section SEM of a substrate material 20 comprising a plurality of circular recesses 40 with undercuts 480. As can be seen from the scale bar and measurement, the opening width 430 of recesses 40 is approximately 10 µm in this example.

Fig. 5c shows a perspective SEM of a composite 10 comprising a coating layer 30 and substrate material 20 with a plurality of recesses where the coating layer has been partially removed. It can be seen that after depositing a coating layer onto a substrate surface that contains a plurality of recesses, these recesses transfer to the surface of the coating layer 300.

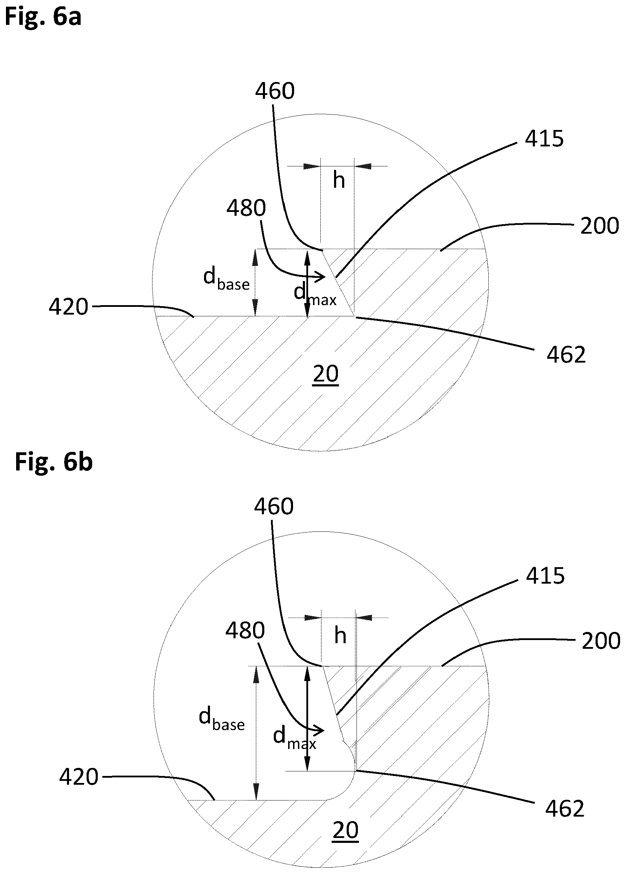

Fig. 6a and 6b show two alternative magnifications of sidewalls 480 of recesses 40.

As can be seen in Fig. 6a, the recess 40 has an undercut 480 with a straight sidewall 430 that increases the width of the recess from the opening towards the base 420. The opening perimeter 470 is located around the opening of recess 40, the maximum perimeter 472 is located at a maximum depth dₘₐₓ 452 below the surface 200, which in this example equals the recess depth d_{base} 450. The largest inner circle that fully fits into the opening perimeter 470 defines the surface width w_{surf} 430 and the largest inner circle that fully fits into the maximum perimeter 472 defines the maximum width wₘₐₓ 432. The difference of wₘₐₓ minus w_{surf} corresponds to the twice the width of the overhang h 444.

As can be seen in Fig. 6b, recess 40 has an undercut 480 with a sidewall 415 of varying shape. The opening perimeter 460 is located around the opening of recess 40, the maximum perimeter 462 is located at a maximum depth dₘₐₓ 452 below the surface 200. The depth dₘₐₓ is greater than zero but less or equal than the depth d_{base} of the recess 40, meaning that the maximum perimeter 462 and hence maximum width wₘₐₓ is located between the substrate surface 200 and the recess base 420.

The largest inner circle that fully fits into the opening perimeter 460 defines the surface width w_{surf} and the largest inner circle that fully fits into the maximum perimeter 462 defines the maximum width wₘₐₓ. The difference of wₘₐₓ minus w_{surf} corresponds to the twice the width of the overhang h.

The sidewall 415 of any recess 40 can have any shape if a depth dₘₐₓ exists at which the width of the recess is greater than the width at the opening of the recess, i.e., an overhang h exists that is greater than zero.

### Example

The inventive process for depositing a mechanically interlocked coating upon a substrate is shown in the diagram of Fig. 7 and explained in detail in the following.

Process step a) shows the starting point, providing a single crystal silicon wafer as the substrate.

After cleaning the substrate surface 200 carefully a photoresist 210 providing a reasonable selectivity against the reactant etch gas composition is deposited by spin coating or spraying to achieve a reasonable thickness (e.g., 1 to 2 µm) and homogeneity. To obtain a reasonable resolution and selectivity, standard photoresists for semiconductor fabrication are recommended.

The photoresist is dried / prebaked according to the recommended parameters provided by the photoresist manufacturer. To pattern the photoresist, a photolithographic mask and an UV Exposure apparatus are needed. The photoresist is exposed through the photoresist mask and the exposed photoresist regions 220 are developed according to the recommended parameters provided by the photoresist manufacturer.

After development, a post bake may be recommended to increase the selectivity of the following etching process. Processing of the photoresist is schematically shown in process steps b).

The recesses 40 are formed by isotropic etching of the unprotected regions 230 of the substrate, utilizing the photoresist 210 as mask with sufficient stability against the reactants. If a small recess depth is required, it is advantageous to utilize dry etching processes such as (D)RIE or ICP. In case of a silicon substrate, advantage can be taken from DRIE adapted processes, alternating side wall passivation and isotropic etching steps. Details can be found e.g., in M. D. Henry, "ICP Etching of silicon for micro and nanoscale devices", Thesis California Institute of Technology, May 19, 2010. Such steps allow for a precise control of a desired shape of the sidewall 415 and an undercut 480. This process is shown in process step c).

After recess 40 formation, the photoresist 210 is removed utilizing the recommended solutions by the photoresist manufacturer, shown in process step d).

A coating process is performed using a planar silicon substrate (e.g., wafer) coated with a 10 µm thick nano-crystalline diamond CVD film. As the diamond growth or deposition, respectively, does not spontaneous start on a clean silicon surface, a nucleation step must be performed in advance. Here, a water-based nucleation slurry containing purified diamond particles (seeds) are used. The size of the seeds should be much smaller than the recess depth d_{base} to enable a high nucleation density. The nucleation process is performed by dipping the Silicon wafer into the slurry and followed by a water-based rinsing and a drying step.

After nucleation, the wafer is placed e.g., in a hot filament CVD system and the growth process is started. The hot filament CVD growth of diamond is known to be rather isotropic as no ion bombardment is involved. Thus, the recessed silicon surface is overgrown or covered, respectively, and the residual diamond growth surface smoothens out with increasing diamond film thickness as seen in the cross-sectional SEM pictures. Process step e) shows the schematically the final result.

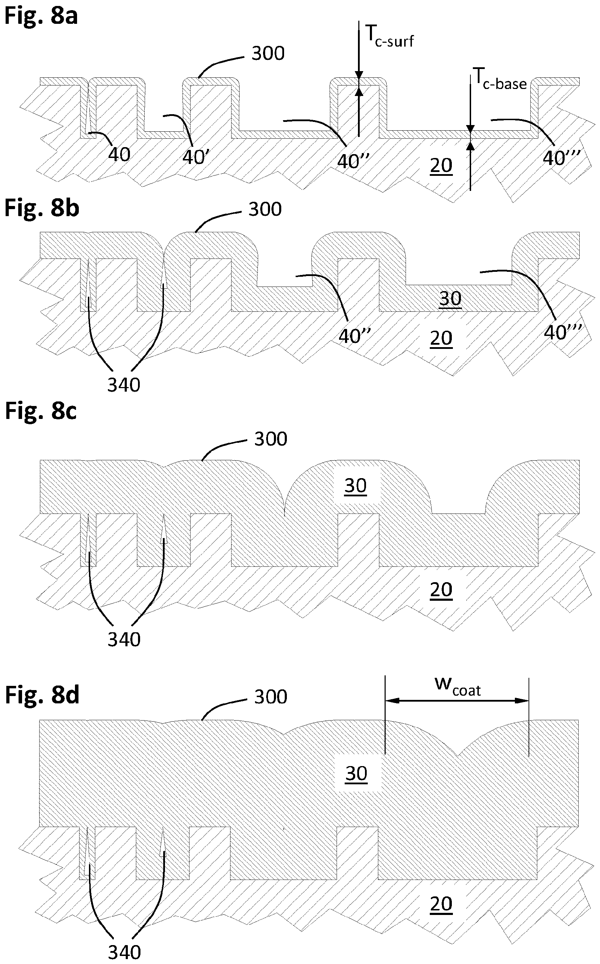

Figs. 8a to d. illustrate the stages of the deposition of a coating layer onto a structured substrate that contains a plurality of recesses (40, 40', 40", 40‴) with different widths to illustrate the importance to choose the correct recess width w_{surf} and aspect ratio w_{surf}/d_{base}. It has been found that the deposition rate strongly depends on this aspect ratio w_{surf}/d_{base} and that the growth rate at the recess base 420 is in general lower than the growth rate at the coating surface 300 resulting in different coating thicknesses T_{c-surf} and T_{C-base} (see fig. 8a). With increasing coating thickness (fig. 8b, 8c, 8d), the coating layer at the coating surface 300 may form a continuous layer before the recesses have been filled with the coating material which leads to the formation of cavities 340 in the coating layer 30. These cavities are undesirable because they reduce the adhesion between the substrate material 20 and the coating layer 30. Knowledge of the deposition rates makes it possible to choose the correct aspect ratio of the recess width to the recess depth w_{surf}/d_{base}. For the CVD growth of nano-crystalline diamond a ratio w_{surf}/d_{base} in the range of 1 to 20 is preferred.

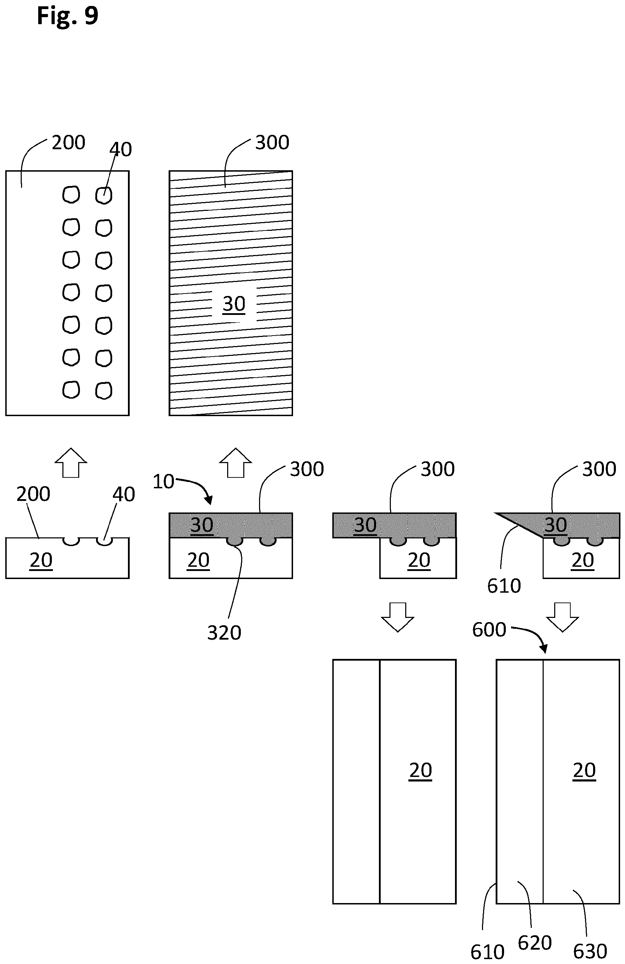

Fig. 9 shows a schematic top view and cross sections of a cutting element at different stages during the composite and blade making process. The cutting element 600 with a cutting edge 610 and a cutting element body 620 are produced from the layered composite 10, whereby the coating layer 30 comprises a hard coating from the selection of materials disclosed above. Cutting edges 610 may be produced by partially removing the substrate material 20 until only the coating layer 30 remains and subsequently forming a cutting edge 610 in the portion of the coating layerthat is unsupported by substrate material. If the substrate material 20 contains recesses 40 on the surface 200, the coating layer 30 contains protrusions 320 that were formed during the coating process when the coating materials filled the recesses 40 in the substrate material 20. These protrusions 320 mirror the shape and distribution of the recesses 40 that were created in the surface 200 of the substrate material 20 prior to depositing the coating layer 30. However, in the case of cutting edges 610 formed in the unsupported coating layer 30 by partially removing the substrate material 20, it is desirable not to have protrusions 320 on the cutting edges 610. Protrusions 320 on the cutting edge 610 may cause the cutting edge 610 to be ragged and the cutting bevel 620 to be rough which may lead to poor cutting performance and instability of the cutting blade 600. It is therefore desirable to avoid protrusions 320 at the cutting edge 610, which requires that recesses 40 must not be created on the surface 200 of the substrate 20 in regions where the substrate 20 will be removed after the coating process to form cutting bevels 620 with cutting edges 610.

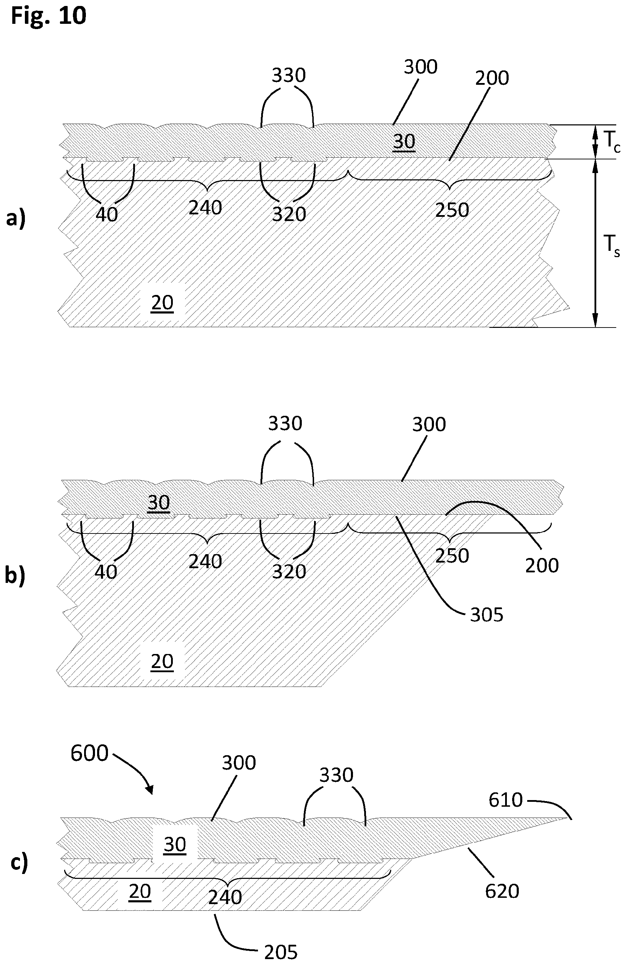

Fig. 10a to 10c show the optional cutting edge formation process on a substrate surface that has a region 240 with recesses 40 and a region 250 without recesses 40 so that a cutting element 600 with a smooth cutting bevel 620 and a smooth cutting edge 610 without protrusions 320 or recesses 40 can be achieved.

Fig 10 shows the initial stage a), where in contrast to Fig. 7 step e), the recesses are limited to a region 240 that will form the cutting element body 630. These recesses 40 remain "buried" in the cutting element body 630 and provide the required adhesion between the substrate 20 with a thickness Tₛ and the coating 30 with a thickness T_{c}. The regions 250 without recesses 40, that will form the exposed cutting bevel 620 with cutting edge 610. To define the different regions with and without recesses, the photoresist mask of process step 520 has to be adapted accordingly.

Process step b) shows the result after partially removing substrate 20 from the region 250 without recesses 40. This is achieved by applying a photolithographic (PL) mask (i.e., photoresist or an additional mask layers like SiO₂ or Si₃N₄) onto the substrate backside surface 205. This mask must be aligned with regions on the substrate surface 200. The photoresist exposure can be realized utilizing a double side aligner. After completion of the photoresist process the substrate material is removed by wet chemically etching. The coating 30 acts here also as mask against etch attack from the coating surface 300.

The geometry of the substrate sidewall 415 is dependent on the type of etch chemistry. In case of anisotropic wet chemical etching, it may have the shape of a straight bevel.

Forming the cutting bevel 620 with a cutting edge 610 can be realized by simultaneous etching of the hard coating 30 and the substrate 20, as described e.g., in DE 198 59 905, resulting in sharp cutting edges within the coating 30. Since the recesses 40 are limited to the region 240 that are "buried" in the cutting element body 630, the cutting edge 610 and cutting bevel 620 are free from protrusion 320 and remain smooth. The final result is shown schematically in step c).

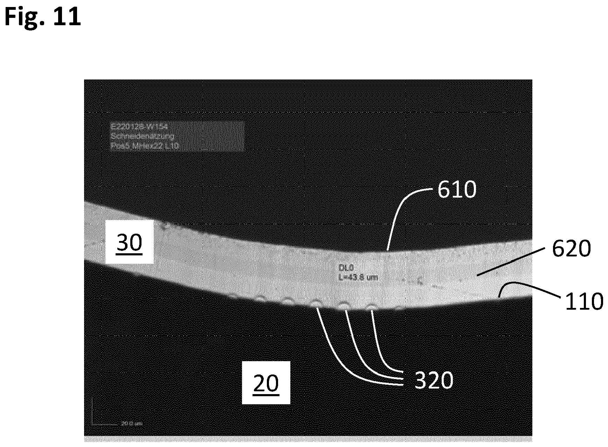

Fig. 11 shows an electron microscopic picture of the top view (from the substrate backside surface 205) of a cutting element 600. Bright areas correspond to the exposed diamond cutting bevel 620. In this case the cutting edge 610 is not straight but curved. From misalignment or over-etching some protrusions 320 appear in the cutting bevel close to the substrate interface 110. Most of the cutting bevel 620 and cutting edge 610 is smooth and free from protrusions.

## Claims

1. Composite (10) of a substrate (20) coated with a mechanically interlocked coating (30) comprising or consisting of
• a substrate (20) with a surface (200) in contact with a coating (30)
• the substrate (20) has at least in regions of the surface (200) a plurality of recesses (40, 40', 40", 40‴) at the surface (200)
• the coating (30) extends into the recesses (40, 40', 40", 40‴) of the substrate (20) forming a mechanical interlocking structure between substrate (20) and coating (30).

2. Composite of claim 1,
**characterized in that** the recesses (40, 40', 40", 40‴) have a width w_{surf} in a range of 100 nm to 100 µm, preferably from 500 nm to 20 µm, and a depth d_{base}, in a range 50 nm to 5 µm, preferably from 100 nm to 2 µm, with the proviso that the aspect ratio w_{surf}/d_{base} is in the range from 0.20 to 25, preferably in the range from 1 to 20, and more preferably in the range from 5 to 15.

3. Composite of any of claims 1 or 2,
**characterized in that** the recesses (40, 40', 40", 40‴) are arranged such that the ratio wₚₐᵢᵣ/s of the average width wₚₐᵢᵣ of any pair of two adjacent recesses to the spacing s of the same pair of two adjacent recesses is in the range of 0.1 to 0.95, preferably 0.3 to 0.9, more preferably 0.4 to 0.8, and even more preferably 0.5 to 0.75.

4. Composite of any of claims 1 to 3,
**characterized in that** the recesses (40, 40', 40", 40‴) are arranged such that the ratio s/dₚₐᵢᵣ of the spacing s of any pair of two adjacent recesses to the average depth dₚₐᵢᵣ of the same pair of tow recesses is in the range from 0.25 to 20, preferably in the range from 0.5 to 15, and more preferably in the range from 1 to 12.

5. Composite of any of claims 1 to 4,
**characterized in that** the substrate (20) comprises or consists of a material selected from the group
• metals, preferably titanium, nickel, chromium, niobium, tungsten, tantalum, molybdenum, vanadium, platinum, germanium, iron, and alloys thereof, in particular steel,
• ceramics comprising at least one element selected from the group consisting of carbon, nitrogen, boron, oxygen or combinations thereof, preferably silicon carbide, zirconium oxide, aluminum oxide, silicon nitride, boron nitride, tantalum nitride, TiAIN, TiCN, and/or TiBz,
• glass ceramics; preferably aluminum-containing glass-ceramics,
• composite materials made from ceramic materials in a metallic matrix (cermets),
• hard metals, preferably sintered carbide hard metals, such as tungsten carbide or titanium carbide bonded with cobalt or nickel,
• single crystalline silicon or germanium, preferably with the crystalline plane parallel to the second face (2), wafer orientation <100>, <110>, <111> or <211>,
• glass or sapphire,
• polycrystalline or amorphous silicon or germanium,
• mono- or polycrystalline diamond, diamond like carbon (DLC), adamantine carbon and
• combinations thereof,
preferably selected from the group consisting of silicon, steel and combinations thereof.

6. Composite of any of claims 1 to 5,
**characterized in that** the substrate material (20) fulfills at least one of the following properties:
• a thermal expansion coefficient of 0.9 to 20 ppm/K (at 20°C), preferably of 1 to 15ppm/K and even more preferably from 2 to 5 ppm/K
• a Young's modulus of 50 to 1000 GPa, preferably of 75 to 800 GPa and even more preferably from 100 to 400 GPa.

7. Composite of any of claims 1 to 6,
**characterized in that** the coating (30) is a hard coating selected from the group consisting of
• oxides, nitrides, carbides, borides, preferably aluminum nitride, chromium nitride, titanium nitride, titanium carbon nitride, titanium aluminum nitride, cubic boron nitride
• boron aluminum magnesium
• carbon, preferably diamond, nano-crystalline diamond, micro-crystalline diamond, polycrystalline diamond, mono-crystalline diamond, diamond like carbon (DLC) like tetrahedral amorphous carbon, and
• combinations thereof,
more preferably the coating (30) is a hard coating selected from the group consisting of diamond, nano-crystalline diamond, micro-crystalline diamond, polycrystalline diamond, mono-crystalline diamond, diamond like carbon (DLC) like tetrahedral amorphous carbon and combinations thereof.

8. Composite of claim 7,
**characterized in that** the hard coating material fulfills at least one of the following properties:
• a modulus of elasticity of less than 1,200 GPa, preferably less than 900 GPa, more preferably less than 750 GPa, and even more preferably from 50 GPa to 500 GPa,
• a transverse rupture stress σ₀ of 1 GPa to 15 GPa, preferably of 2.5 GPa to 10 GPa, more preferably of 5 GPa to 8 GPa,
• a hardness of 20 GPa to 100 GPa, preferably 25 GPa to 50 GPa,
• an average grain size d₅₀ of the nano-crystalline diamond of 1 to 100 nm, preferably from 5 to 90 nm, more preferably from 7 to 30 nm, and even more preferably from 10 to 20 nm, and
• a thermal expansion coefficient of 0.9 to 8 ppm/K (at 20°C), preferably of 1 to 5ppm/K and even more preferably from 1.2 to 3 ppm/K

9. Composite of any of claims 1 to 8,
**characterized in that** the coating (30) is a first coating deposited on the substrate at least in regions and on the first coating at least one further coating is deposited at least in regions, preferably a second coating is deposited on the first coating at least in regions..

10. Composite of any of claims 1 to 9,
**characterized in that** the coating (30) or the at least one further coating is a soft coating selected from the group consisting of low-friction materials, preferably selected from the group consisting of polymers, in particular fluoropolymers (like PTFE), silicon-based polymers (like silicones), parylene, polysilazanes, polyvinylpyrrolidone, polyethylene, polypropylene, polymethyl methacrylate, graphite, and combinations thereof.

11. Composite of any of claims 1 to 10,
**characterized in that** the recesses (40, 40', 40", 40‴) have no corners, preferably the recesses have a circular or ellipsoidal shape.

12. Composite of any of claims 1 to 11,
**characterized in that** the recesses (40, 40', 40", 40‴) comprise a sidewall in the shape of an undercut, wherein the width of the recesses (40, 40', 40", 40‴) increases at a depth between the surface and the lowest point on the base of the recess to a width greater than the width of the opening of the recesses (40, 40', 40", 40‴).

13. Composite of any of claims 1 to 12,
**characterized in that** the substrate (20) has a plurality of recesses (40, 40', 40", 40‴) at the substrate surface (200) arranged over the entire substrate surface (200) or the substrate (20) has in regions of the substrate surface (200) a plurality of recesses (40, 40', 40", 40‴) at the surface (200).

14. Composite of any of claims 1 to 13,
**characterized in that** the coating (30) has a thickness T_{c} of 100 nm to 50 µm, preferably 150 nm to 20 µm, more preferably 200 nm to 15µm and/or
the substrate (20) has a thickness Tₛ of 25 to 500 µm, preferably 40 to 250 µm, more preferably 50 to 220 µm and/or
the composite (10) has a total thickness Tₜₒₜ of 25 to 2000 µm, preferably 50 to 1000 µm, more preferably 100 to 400 µm.

15. Composite of any of claims 1 to 14,
**characterized in that** the ratio d_{base}/T_{c} of the depth d_{base} of the recesses (40, 40', 40", 40‴) to the thickness of the coating (30) T_{c} is in a range of 0.01 to 15, preferably 0.1 to 5, more preferably 0.05 to 2.

16. Cutting element formed from the composite of any of the preceding claims, preferably a knife blade, razor blade, scalpel, knife, machine knife in slitting-, burst- and crash cutting systems, scissors or shear cutting systems.

17. A method for depositing a mechanically interlocked coating upon a substrate with the steps of:
• Providing a substrate (20) with a surface (200),
• forming an etching mask with openings at the surface (200) of the substrate (20),
• etching the substrate (20) through the openings in the etching mask to form a plurality of recesses (40, 40', 40", 40‴) at the surface (200) of the substrate (20) by reactive ion etching,
• optionally, removing the etching mask from the substrate (20), and
• depositing a coating (30) onto the substrate surface (200) and into the plurality of recesses (40, 40', 40", 40‴).
